(19) Europäisches Patentamt
European Patent Office
Office européen des brevets

(11) Veröffentlichungsnummer: **0 168 706**
**B1**

# (12) EUROPÄISCHE PATENTSCHRIFT

(45) Veröffentlichungstag der Patentschrift: **29.06.88**

(51) Int. Cl.⁴: **C 23 F 1/26**

(21) Anmeldenummer: **85108130.7**

(22) Anmeldetag: **01.07.85**

## (54) Verfahren zum Herstellen von masshaltigen Titanstrukturen.

(30) Priorität: **02.07.84 DE 3424329**

(43) Veröffentlichungstag der Anmeldung: **22.01.86 Patentblatt 86/4**

(45) Bekanntmachung des Hinweises auf die Patenterteilung: **29.06.88 Patentblatt 88/26**

(84) Benannte Vertragsstaaten: **BE DE FR**

(56) Entgegenhaltungen:
**US-A-2 981 610**
**US-A-3 052 582**
**US-A-3 844 859**
**US-A-3 960 741**
**US-A-4 345 969**

**CHEMICAL ABSTRACTS, Band 94, Nr. 12, 23. März 1981, Seite 739, Nr. 94770s, Columbus, Ohio, US**

(73) Patentinhaber: **Siemens Aktiengesellschaft Berlin und München, Wittelsbacherplatz 2, D-8000 München 2 (DE)**

(72) Erfinder: **Horn, Heinrich A., Dipl. Geol., Preysingstrasse 29, D-8000 München 8 (DE)**
Erfinder: **Primig, Robert, Ing., Milchstrasse 12, D-8000 München 8 (DE)**

**EP 0 168 706 B1**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

LIBER, STOCKHOLM 1988

**Beschreibung**

Die vorliegende Patentanmeldung betrifft ein Verfahren zum Herstellen von maßhaltigen Strukturen aus Titan im 0,05 bis 1,0 µm-Schichtdickenbereich unter Verwendung einer aus Fotolack bestehenden Maskierung durch naßchemisches Ätzen in einem Flußsäure-Salpetersäure-Ätzgemisch, dem ein Metallionen-Komplexbildner zugesetzt wird, sowie seine Verwendung

Metallschichten aus Titan finden in der Elektronikindustrie, insbesondere in der Halbleitertechnologie zunehmend Verwendung als Kontakt- und Elektrodenmaterial.

In diesem Anwendungsbereich ist es erforderlich, Titanschichten, die durch ein geeignetes physikalisches Verfahren, zum Beispiel durch Elektronenstrahlverdampfung, auf ein Substrat aufgebracht worden sind, in Form von Leiterbahnen, Anschlußflecken oder Elektroden zu strukturieren. Die Strukturierung erfolgt in der Weise, daß mittels Verfahrensschritte der Fotolithographie eine aus Fotolack bestehende Maskierungsschichtstruktur auf der Titanschicht gebildet wird und die freiliegenden Titanschichtbereiche weggeätzt werden.

Es ist bekannt, den Titanätzprozeß auf naßchemischem Wege durchzuführen, wobei als Ätzmittel Flußsäure, Salpetersäure und Ammonfluorid in den verschiedenen Kombinationen und Konzentrationen verwendet werden. Dabei geht Titan nach der Reaktionsgleichung

$$Ti + 4HF + H_2O \rightarrow TiF_4 + 4\,H_3O^-$$

in Lösung.

Aus der US-A 4.345.969 ist bekannt, eine Dreischicht-Metallisierung aus Titan, Nickel und Kupfer in einem Ätzgemisch aus Flußsäure, Salpetersäure, Essigsäure und Wasser zu ätzen. Dabei wird Titan insbesondere vom Flußsäureanteil geätzt.

Während bei sehr dünnen (kleiner 0,05 µm) Titanschichten die Ausbildung der Ätzkante unkritisch ist, treten bei dicken Titanschichten Schwierigkeiten in Form von zerklüfteten Ätzflanken, Unterätzungen und Rückständen in freigeätzten Bereichen auf.

Aufgabe der Erfindung ist es, diese Schwierigkeiten zu beseitigen und reproduzierbar maßgetreue Strukturen herzustellen.

Diese Aufgabe wird durch ein Verfahren der eingangs genannten Art dadurch gelöst, daß erfindungsgemäß dem Ätzgemisch als Komplexbildner ein Chelator auf der Basis von Nitrilotriessigsäure, Äthylendiamintetraessigsäure und/oder 3,6-Dioxaoctamethylendinitrilotetraessigäsure zugesetzt wird. Dieser Stoff hat die Aufgabe, Titanionen, die gemäß der obengenannten Reaktionsgleichung einen Fluorkomplex bilden, aus diesem System laufend zu entfernen und als Metallkomplex zu binden.

Die Titan-Chelatbildung wirkt sich auf den Ätzprozeß derart günstig aus, daß senkrechte und nicht zerklüftete Ätzkanten und rückstandsfrei geätzte Bereiche des Substrates entstehen.

Die Chelatbildung wird durch folgende Reaktionsgleichungen bestimmt:

$$TiF_4 + H_4Y \rightarrow TiY + 4\,HF$$

$$TiF_4 + H_3Y^+ + H_30^- \rightarrow TiY + 4\,HF + H_20$$

Die Komplexbildungskonstante nimmt von Nitrilotriessigsäure über Äthylendiamintetraessigsäure zu 3,6-Dioxa-octamethylendinitrilotetraessigsäure (Titriplex VI) zu. Gemäß einem besonders günstigen Ausführungsbeispiel nach der Lehre der Erfindung wird deshalb als Komplexbildner die letztgenannte Verbindung verwendet. Eine Ätzlösung zur Strukturierung einer 0,25 oder 0,5 µm dicken Titanschicht besteht aus:

45 ml HF (40 %-ig), 275 ml $HNO_3$ (65 %-ig) und 19 g 3,6-Dioxaoctamethylendinitrilotetraessigäsure (auch bekannt unter dem Namen Titriplex VI von der Firma Merck), aufgefüllt auf 5 l Wasser.

Die Ätztemperatur wird auf 20 bis 30° C, insbesondere 20 bis 25° C, zum Beispiel auf 22° C, die Ätzdauer bei einer 0,25 µm dicken Titanschicht auf 2 Minuten, bei einer 0,5 µm dicken Titanschicht auf 2,5 Minuten eingestellt.

Die Chelatbildner werden von der chemischen Industrie in Form von Pulvern bzw. Ampullen angeboten (von der Firma Merck unter dem Warenzeichen Titriplex, von der Firma Riedel de Haen als Chelaton oder Idranal).

Das Verfahren nach der Lehre der Erfindung wird inbesondere verwendet zur Herstellung von Titanelektroden für Sensorelemente. Es ist aber ebenso anwendbar bei der Herstellung von Kontaktleitbahnen in der Halbleitertechnologie.

**Patentansprüche**

1. Verfahren zum Herstellen von maßhaltigen Strukturen aus Titan im 0,05 bis 1 µm-Schichtdickenbereich unter Verwendung einer aus Fotolack bestehenden Maskierung durch naßchemisches Ätzen in einem Flußsäure-Salpetersäure-Ätzgemisch, dem ein MetallionenKomplexbildner zugesetzt wird, dadurch gekennzeichnet, daß dem Ätzgemisch als Komplexbildner ein Chelator auf der Basis von Nitrilotriessigsäure, Äthylendiamintetraessigsäure oder 3,6-Dioxaoctamethylendinitrilotetraessigsäure zugesetzt wird.

2. Verfahren nach Anspruch 1 und 2, dadurch gekennzeichnet, daß eine Ätzmischung verwendet wird, die auf 5 l Ätzlösung 45 ml

Flußsäure (40 %-ig), 275 ml Salpetersäure (65 %-ig), 19 g 3,6 Dioxaoctamethylendinitrilotetraessigsäure und Wasser enthält.

3. Verfahren nach Anspruch 2, dadurch gekennzeichnet, daß zur Strukturierung einer 0,25 µm dicken Titanschicht die Ätztemperatur auf 20 bis 25° C und die Ätzzeit auf 2 Minuten eingestellt wird.

4. Verfahren nach Anspruch 2, dadurch gekennzeichnet, daß zur Strukturierung einer 0,5 µm dicken Titanschicht die Ätztemperatur auf 20 bis 30° C und die Ätzdauer auf 2 bis 2,5 Minuten eingestellt wird.

5. Verwendung des Verfahrens nach mindestens einem der Ansprüche 1 bis 4 zur Herstellung von Titanelektroden für Sensorelemente sowie zur Herstellung von aus Titan bestehenden Leitbahnen in der Halbleitertechnik.

## Claims

1. A process for the production of titanium structures having precise dimensions and a layer thickness in the range of between 0.05 and 1 µm, using a photo-resist mask by wet-chemical etching with a hydrofluoric acid/nitric acid etching mixture to which a metal ion complex former is added, characterised in that the complex former which is added to the etching mixture is a chelating agent having a nitrilotriacetic acid, ethylene diaminotetra-acetic acid or 3.6-dioxaoctamethylenedinitrilotetra-acetic acid basis.

2. A process as claimed in Claim 1 and 2, characterised in that an etching mixture is used which, for 5 l etching solution, contains 45 ml hydrofluoric acid (40 %), 275 ml nitric acid (65 %), 19 g 3.6-dioxaoctamethylenedinitrilotetra-acetic acid and water.

3. A process as claimed in Claim 2, characterised in that for the structuring of a 0.25 µm thick titanium layer, the etching temperature is set at 20 to 25° C and the etching time is set at 2 minutes.

4. A process as claimed in Claim 2, characterised in that for the structuring of a 0.5 µm thick titanium layer the etching temperature is set at 20 to 30° C and the etching time is set at 2 to 2.5 minutes.

5. The use of the process claimed in at least one of Claims 1 to 4 for the production of titanium electrodes for sensor elements and for the production of titanium conductor paths in semiconductor technology.

## Revendications

1. Procédé de fabrication de structures en titane à des dimensions exactes, dans la plage d'épaisseurs de couche allant de 0,05 à 1,0 µm et en utilisant un masque constitué d'un vernis photosensible, par gravure chimique par voie humide dans un mélange de gravure d'acide fluorhydrique et d'acide nitrique, auquel est ajouté un agent complexant les ions métalliques, caractérisé en ce qu'il consiste à ajouter au mélange de gravure, comme agent complexant, un agent de chélation à base d'acide nitrilotriacétique, d'acide éthylènediaminotétraacétique ou d'acide 3,6-dioxaoctaméthylènedinitrilotétraacétique.

2. Procédé suivant la revendication 1, caractérisé en ce qu'il consiste à utiliser un mélange de gravure qui contient, pour 5 l de solution de gravure, 45 ml d'acide fluorhydrique (à 40 %), 275 ml d'acide nitrique (à 65 %), 19 g d'acide 3,6 dioxaoctaméthylènedinitrilotétraacétique et de l'eau.

3. Procédé suivant la revendication 2, caractérisé en ce qu'il consiste à régler, pour la structuration d'une couche de titane de 0,25 µm d'épaisseur, la température de gravure entre 20 et 25° C, et la durée de gravure à 2 minutes.

4. Procédé suivant la revendication 2, caractérisé en ce qu'il consiste à régler, pour la structuration d'une couche de titane de 0,5 µm d'épaisseur, la température de gravure entre 20 et 30° C et la durée de gravure entre 2 et 2,5 minutes.

5. Mise en oeuvre du procédé suivant l'une au moins des revendications 1 à 4, pour la fabrication d'électrodes en titane pour des éléments de détection, ainsi que pour la fabrication de pistes conductrices en titane dans la technique des semi-conducteurs.